# EUROPEAN PATENT APPLICATION

(11) **EP 0 571 929 A2**
(43) Date of publication of application: **01.12.1993**
(21) Application number: 93108370.3
(22) Date of filing: 24.05.1993
(51) Int. Cl.: G03F 1/14

(54) **Dummy diffraction mask**

(30) Priority: 26.05.1992 KR 888892; 04.12.1992 KR 2336192
(71) Applicant: ELECTRONICS AND TELECOMMUNICATIONS RESEARCH INSTITUTE, Daejeon-shi (KR)
(72) Inventor: Oh, Yong Ho, Joong-Gu, Daejeon (KR); Jeon, Young Jin, Yuseong-Gu, Daejeon (KR); Cha, Jae Hyoun, Seo-Gu, Daejeon (KR); Kim, Hyo Joong, Daejeon (KR)
(74) Representative: Kador & Partner

(57) **Abstract**

A dummy diffraction mask comprises diffraction layers which are used assistantly together with a main mask in a lithography process using an exposure tool and formed into a pattern by which an image transferred to a photoresist on a wafer is prevented from being resolved from a view of the image transfer characteristic of the exposure tool and the characteristic of the photoresist. The dummy diffracion layer may be used assistantly with the main mask in a process effected by using an exposure tool employing a modified illumination or super resolution filter and has a repeated fine pattern by which a image to be transferred to a semiconductor wafer is prevented from being resolved.

## Description

### BACKGROUND OF THE INVENTION

### 1. Field of the Invention

The present invention relates to a dummy diffraction mask suitable for use to form a fine pattern structure of a semiconductor device by way of an exposure tool.

### 2. Description of the related Art

In manufacturing such a semiconductor integrated circuit, a technique to form a fine pattern structure by using an exposure tool is substantially required to assure high resolution and focusing depth to the fine pattern.

To improve characteristics of resolution and focusing depth of such a fine pattern in a lithography process using such an exposure tool, application of a phase-shift mask is positively studied, recently. By the way, such a phase-shift mask is not yet put to practical use in the art because a process of designing and manufacturing the mask is very difficult and a technology to inspect and repair the mask is difficult as well.

In fact, such resolution is an important matter in a case of manufacturing such a semiconductor device by way of an exposure process.

As measures to improve resolution and focusing depth in such an exposure process and thus achieve stability of the process, there are (1) improving such an exposure tool, (2) reforming a mask and (3) improving a photoresist.

As a typical countermeasure which has a structure improved than an ordinary mask to assure high resolution and stabilize a process of manufacturing the structure, the phase-shift mask has been well known. But, such a phase-shift mask is not yet put to practical use because a process of designing and manufacturing thereof is very difficult and an inspection and a repairing work thereto are not easy as well.

With a recent tendency to enhance resolution and focusing depth, a modified illumination and super resolution filter suited to increase resolution and focusing depth by controlling the nature of an incident light beam, that is, an incidence angle of the light beam and distribution of the light beam on an ordinary mask by way of an exposure tool are positively studied, recently.

In accordance with the basic principle of such a modified illumination effected by an improved illumination system of the exposure tool for enhancing the resolution and focusing depth, the light beam to the mask is slantingly introduced to irradiate the mask so as to indirectly reduce a 0th-order noise component from a FOURIER component of a mask transfer function. Then, higher-order components of which are not conventionally allowed to be transferred due to a limited size of a lense in a projection system are transferred to thereby obtain highly improved resolution and focusing depth.

The super resolution filter effectively employs the nature of the FOURIER component of the light beam passed through the mask, which is focused on an entrance pupil of the projection lense, and shields the centre of the entrance pupil to directly reduce the 0th-order noise component of the mask transfer function.

In afore-mentioned studies, the simple improvment of the conventional exposure tool causes to deteriorate the yield as well as the possibility of practical use. Therefore, new measures and/or tools must be developed so as to enhance resolution and focusing depth. Further, the conventional exposure tool provides a relatively excellent effect for a constantly repeated pattern, but it can not provide a desired effect for a pattern presented with irregularly repeated pattern having mutually different period or isolated pattern and further exerts a bad influence upon the pattern. For this reason, the attempt to overcome the disadvantage is diversely made at present.

### SUMMARY OF THE INVENTION

Accordingly, an object of the present invention is to provide a dummy diffraction mask capable of improving the nature of light beam introduced into a main mask (or passed through the main mask), that is, an incidence angle (or projection angle) and distribution of the light beam to an incidence angle by using an improved characteristic of the mask rather than an exposure tool, thereby enhancing resolution and focusing depth.

In order to achieve the object, according to a preferred aspect of the present invention there is provided a dummy diffraction mask of which diffraction layers are assitantly employed together with a main mask in a lithography process using an exposure tool and formed into a pattern by which an image to be transferred to a photoresist on a semicondutor wafer is prevented from being resolved from a view of the image transfer characteristic of the exposure tool and the characteristic of the photoresist.

Another aspect of the present invention, there is provided a dummy diffraction mask suitable for forming a dummy diffraction layer which is used assistantly with a main mask in a process effected by using an exposure tool employing a modified illumination or super resolution filter, the dummy diffraction layer being into a repeated fine pattern by which an image to be transferred to a semiconductor wafer is prevented from being resolved.

According to a preferred example of the present invention, the dummy diffraction layers are formed in single-layered or multi-layered structure and formed integrally with or separately from the main mask.

Also, the dummy diffraction layer of the dummy diffraction mask is made of any one selected from a light shielding film pattern made of, for example, Cr, a transparent film pattern and a quartz substrate-etched pattern, or the mixture thereof.

The pattern forming the dummy diffraction layer is composed of a fine pattern on which an image transferred to the photoresist on the wafer is prevented from being resolved from the viewpoint of the image transfer characteristic of the exposure tool and the characteristic of the photoresist and formed with one-or two-dimensional periodic grating pattern.

The grating patterns forming the dummy diffraction layers has a period as much as integral number times than that of the repeated pattern of the light shielding film of the main mask. A distance between the dummy diffraction layers and the mask is set to be relatively larger than the period of the repeated patterns of the dummy diffraction layers.

According to a highly preferred example of the present invention, the dummy diffraction layers may be composed of patterns of which each of the repeated pattern area of different period is different in direction, respectively.

The above and other objects, features and advantages of the invention will be apparent from the following description taken with reference of the accompanying drawings.

### BRIEF DESCRIPTION OF THE DRAWINGS

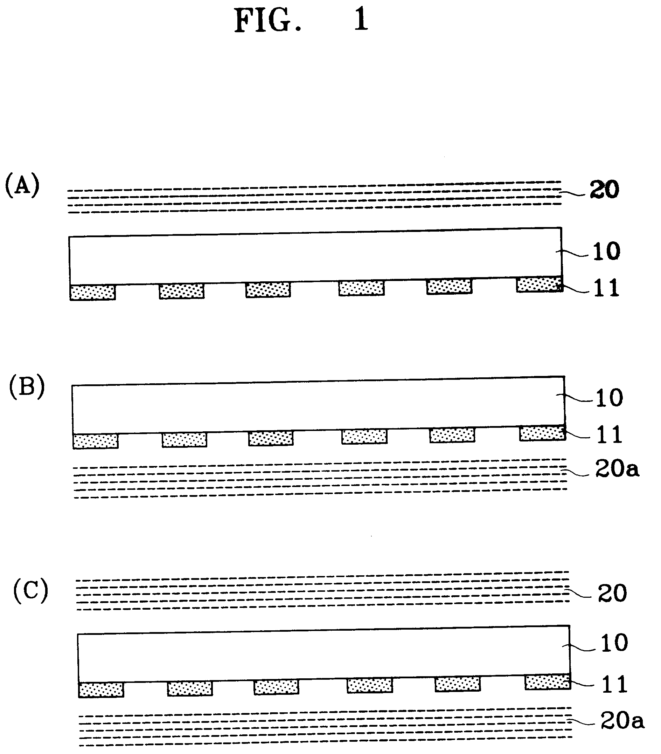

- Fig. 1: is an exemplary view showing an arrangment of a main mask and a diffraction layer of a dummy diffraction mask according to the present invention, wherein (A) shows a structure of the diffraction layer laid on an upper side of the main mask, (B) shows a structure of the diffraction layer laid on the lower side of the main mask, and (C) shows the diffraction layers laid on the upper and lower portions of the main mask ;

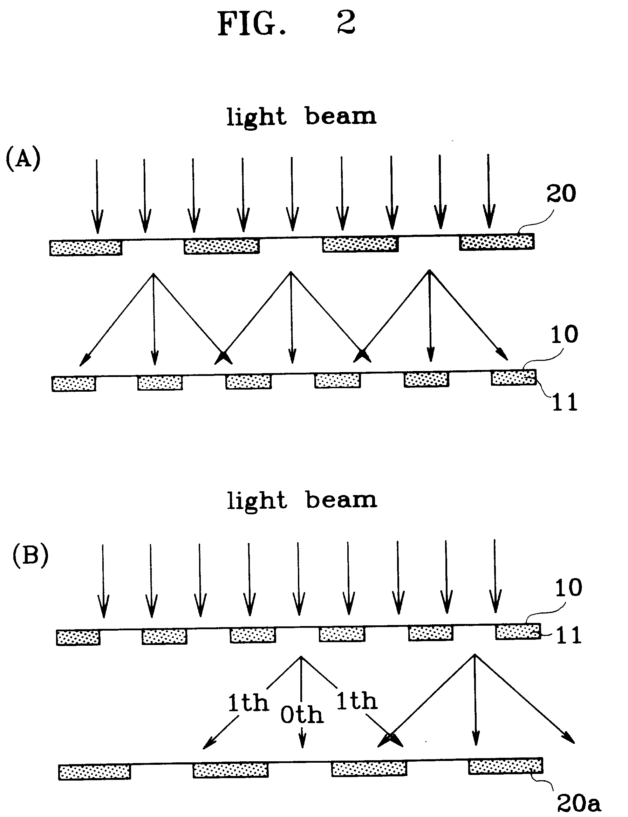

- Fig. 2: is a view illustrating an important role of the diffraction layer in Fig. 1, wherein (A) illustrates a role of the upper diffraction layer and (B) illustrates a role of the lower diffraction layer ;

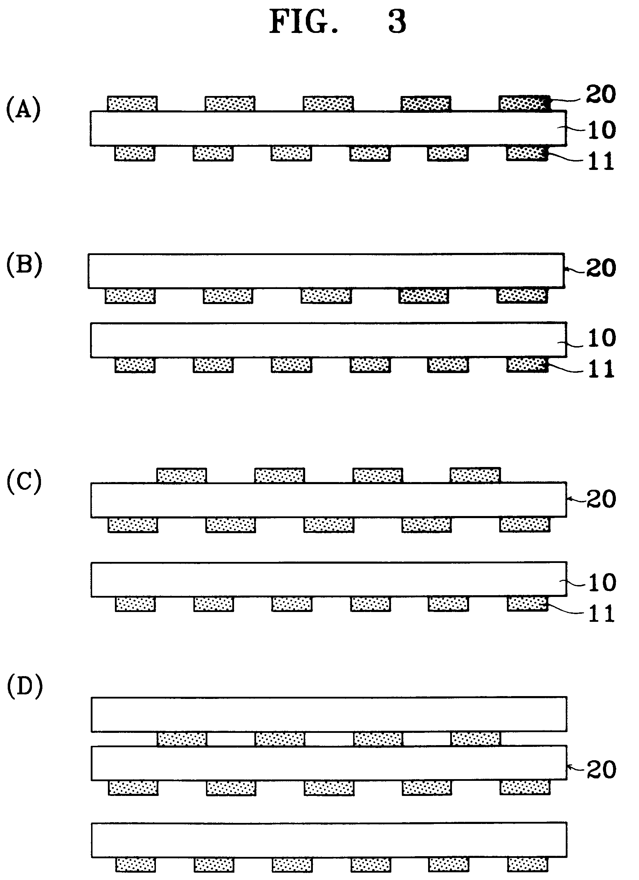

- Fig. 3: is a view showing modified structures of the dummy diffraction mask according to the present invention ; wherein (A) shows a single-structured diffraction layer, (B) shows a separative single-structured diffraction layer formed , (C) shows an integral multi-structured diffraction layer and (D) shows a separative multi-structured diffraction layer ; and,

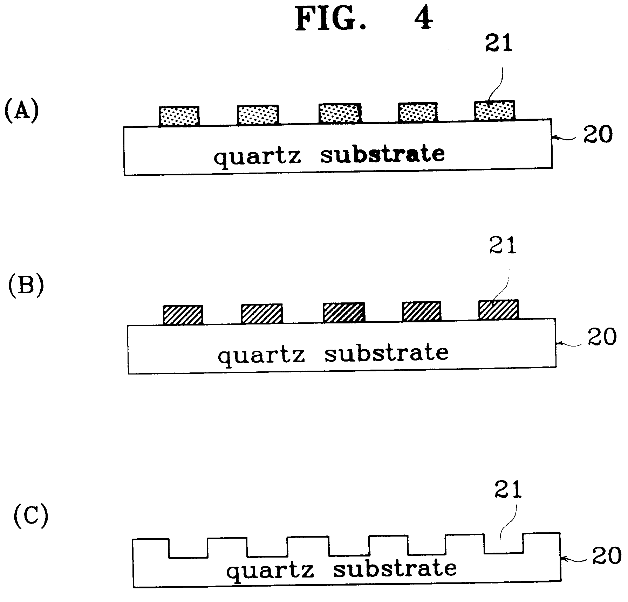

- Fig. 4: is view showing structures based of material of the dummy diffraction layer according to the present invention, wherein (A) shows a diffraction layer formed into a light shielding film (Cr) pattern, (B) shows a diffraction layer formed in a quartz substrate-eached pattern.

### DETAILED DESCRIPTION OF THE INVENTION

Thereinafter, the present invention will be described with reference to the drawings.

Referring to Fig. 1 showing a structure of a dummy diffraction mask of the present invention, a diffraction layer, generally designated 20, of a repeated fine pattern is formed over the upper side or lower side (or upper and lower sides) of a main mask 10. By this diffraction layer 20, an image transferred to a photoresist on a semiconductor wafer is prevented from being resolved from the viewpoint of an image transfer characteristic of an exposure tool and the characteristic of the photoresist. In the drawing, reference numeral 11 denotes a light shielding pattern which is selectively formed on the main mask 10.

As seen from Fig. 1 (A), the dummy diffraction layer 20 on the upper side of the main mask 10 serves to reduce the amount of light beam vertically introduced to the main mask 10 and increase the amount of light beam introduced to the main mask 10 with a constant incidence angle. This can be achieved by the light beam diffraction phenomenon in the diffraction layer 20 and the interference of the light beam diffracted.

At this time, according to the present invention, it is contemplated that the light beam takes a desired incidence angle and distribution depending upon the incidence angle in accordance with a size and shape of the pattern of the diffraction layer 20 so as to be irradiated to the main mask 10.

As shown in fig. 1 (B), the lower diffraction layer 20a which is formed on the lower side of the main mask 10 serves to directly reduce a 0th-order noise components of the light beam introduced to the main mask 10 by the diffraction phenomenon of the light beam, so that resolution and focusing depth of an ordinary mask can be extremely enhanced.

The dummy diffraction mask 20 according to the present invention has a structure in that a light incidence direction can be controlled by the mask rather than the exposure tool. As a result, the diffraction layers 20 and 20a can be variously designed in conforming with the pattern of the main mask 10 and a defect occurred by the existing exposure tool can be overcomed effectively.

Further, when the dummy diffraction mask is used together with the exposure tool having a modified illumination or super resolution filter, the same can be employed to suppress an inclined incidence effect of the light beam and a bad effect acted to remaining pattern excluding the pattern to be subjected can be thus reduced considerably.

Moreover, the degree of difficulty in designing and manufacturing the dummy diffraction mask of the present invention is of the same as that of manufacturing the existing mask. Therefore, the dummy diffraction mask 20 can be put to practical use by a known semiconductor device manufacturing technology.

As described previously, although the dummy diffraction mask is formed as the upper diffraction mask 20 or the lower diffraction 20a, as shown in Figs.1 (A) and (B), if the diffraction mask is formed as the upper and lower diffraction layers 20 and 20a as shown in Fig. 1 (C), then the inclined incidence components of the light beam is increased and, simultaneously, the 0th-order noise component is directly reduced. The role of the diffraction layers 20 and 20a will be now described Figs.2 (A) and (B).

Referring to Fig. 2 (A), when the dummy diffraction mask is employed as the upper diffraction layer 20, the light beam vertically introduced to the upper diffraction layer 20 is reduced while the inclined light beam to the upper diffraction layer 20 is increased.

While the dummy diffraction mask of the present invention is used to form the lower diffraction layer 20a, the 0th-order noise component of a part of the light which is introduced to the lower diffraction layer 20a through the main mask 10 is shielded and reduced.

Fig. 3 shows an exemplary structure in that the dummy diffraction mask of the present invention is used to form the light shielding film and various diffraction layers are laid on the upper side of the main mask 10, respectively.

More particularly, Fig. 3 (A) shows an example of the upper diffraction layer 20 integrally formed with the main mask 10 and Fig. 3 (B) shows another example of the single-structured upper diffraction layer 20 separately formed with the main mask 10. Figs. 3 (C) and (D) show the upper layer 20 having multi-structured integrally or separately formed with or from the main mask 10.

Referring to Fig. 3, while the diffraction layer 20 is laid on the upper side of the main mask 10, it is to be understood that when the diffraction layer having the same or similar to the structure of the layer of Fig. 2 is formed below the main mask 10, the same effect as that of the diffraction layer of Fig. 2 can be achieved sufficiently.

Preferably, when, considering the relation between the pattern formed on the substrate, for example a quartz substrate and that of the shielding film 11 formed on the main mask 10, the period of the repeated pattern on the dummy diffraction layer 20 is relatively larger than that of the repeated pattern of the shielding film 11 by integral number times, the light beam vertically introduced through the dummy diffraction layer is reduced and the slantly introduced light component is increased, thereby obtaining a good result in improving resolution and focusing depth of the mask. Also, according to the dummy diffraction layer of the present invention, it will be preferred that the distance between the dummy diffraction layer and the main mask is to be larger than the period of the repeated pattern formed on the dummy diffraction layer 20 to improve an effect of the mask.

In addition, according to the present invention, the repeated pattern on the dummy diffraction layer may be preferably different in period, respectively.

Fig. 4 show examples of structures based of materials of the dummy diffraction layer according to the present invention. That is, in the drawing (A) shows a diffraction layer formed in a light shielding film (Cr) pattern, (B) shows a diffraction layer formed in a quartz substrate-etched pattern. Further, the present invention contemplates that the diffraction layer may be formed with a mixture of at least one selected from various diffraction layer patterns shown in figs. 4 (A) through (C).

Although the present invention has been described with reference to the specified examples, it is to be understood that various modifications and changes may be made therein without departing from the spirit and scope of the invention.

## Claims

1. A dummy diffraction mask which is used in a lithography process using an exposure tool, comprising diffraction layers assistantly employed together with a main mask and having a pattern by which an image transferred to a photoresist on a wafer is prevented from being resolved from a view of the image transfer characteristic of the exposure tool and the characteristic of the photoresist.

2. A dummy diffraction mask according to claim 1, wherein said dummy diffraction layers are formed in single-layered or multi-layered structure and formed integrally with or separately from said main mask.

3. A dummy diffraction mask according to claim 1, wherein said dummy diffraction layers are made of any one selected from a light shielding film pattern, a transparent film pattern and a quartz substrate-etched pattern.

4. A dummy diffraction mask according to claim 1, wherein said dummy diffraction layers are made of a mixture of at least two patterns selected from a light shielding film pattern, a transparent film pattern and a quartz substrate-etched pattern.

5. A dummy diffraction mask according to claim 3, wherein said light shielding film is made of Cr.

6. A dummy diffraction mask according to claim 1, wherein said pattern forming said dummy diffraction layers is formed into one-or two-dimensional periodic grating pattern.

7. A dummy diffraction mask according to claim 6, wherein said grating patterns forming the dummy diffraction layers has a period as much as integral number times than that of the repeated pattern of the light shielding film of the main mask.

8. A dummy diffraction mask according to claim 6, wherein a distance between the dummy diffraction layers and the mask is set to be relatively larger than the period of the repeated patterns of the dummy diffraction layers.

9. A dummy diffraction mask according to claim 1, wherein said dummy diffraction layers are formed into a pattern of which each of repeated pattern areas of different period is different in direction, respectively.
